# EUROPEAN PATENT APPLICATION

(11) **EP 3 050 999 A1**
(43) Date of publication of application: **03.08.2016**
(21) Application number: 15780256.2
(22) Date of filing: 16.04.2015
(51) Int. Cl.: C23C 14/34, H01L 21/203

(54) **SPUTTERING TARGET AND SPUTTERING TARGET MANUFACTURING METHOD**

(30) Priority: 17.04.2014 JP 2014085233; 19.03.2015 JP 2015056107
(71) Applicant: Mitsubishi Materials Corporation, Chiyoda-ku Tokyo 100-8117 (JP)
(72) Inventor: ZHANG Shoubin, Sanda-shi Hyogo 669-1339 (JP)
(74) Representative: Hoffmann Eitle
(86) International application number: PCT/JP2015/061703
(87) International publication number: WO 2015/159947

(57) **Abstract**

A sputtering target of the present invention is a sintered body containing: 0.5 at% to 10 at% of at least one metal element selected from Ni and Al; 0.01 ppm by weight to 10000 ppm by weight of B or P; and a balance including Si and inevitable impurities, in which the sintered body has a volume resistivity of 10 Ω_{·}cm or lower, a theoretical density ratio of 85% to 99%, and a bending strength of 65 N/mm² or higher.

## Description

### TECHNICAL FIELD

The present invention relates to a sputtering target containing silicon (Si) as a major component and a method of producing the same, in which target breaking can be suppressed, arcing during sputtering can be reduced, and high-speed film formation can be stably performed.

Priority is claimed on Japanese Patent Application No. 2014-85233, filed April 17,2014, and Japanese Patent Application No. 2015-56107, filed March 19, 2015, the contents of which are incorporated herein by reference.

### BACKGROUND ART

In order to form a silicon (Si) film, a silicon nitride film, or a silicon oxide film, a silicon (Si) sputtering target is frequently used. A Si film is formed using a Si sputtering target as it is. However, a silicon nitride film or a silicon oxide film is generally formed using a Si sputtering target through a reactive sputtering technique in an atmosphere containing nitrogen or oxygen.

In order to form these films, in general, a crystalline Si sputtering target (monocrystalline or polycrystalline Si sputtering target) is used. A crystalline Si sputtering target has advantageous effects of high purity and easy availability. However, there are problems in that breaking is likely to occur during sputtering and that a deposition rate is significantly slow.

Therefore, a technique of improving a deposition rate or breaking resistance through a heat treatment and a chemical etching treatment of the crystalline Si sputtering target has been proposed (for example, refer to PTL 1). On the other hand, a technique of producing a Si sintered body using Si powder in order to improve a deposition rate or breaking resistance has been proposed (for example, refer to PTLs 2 and 3). With this producing method, a high-density sputtering target having a sintered body density of 99% or higher can be obtained.

Further, a sputtering target formed of a silicide containing Si and one selected from the high melting point metal group consisting of Mo, W, Ti, Nb, Cr, and Ta has been proposed (for example, refer to PTL 4). In addition, a method of producing a conductive Si sputtering target has been proposed in which a target material is formed through thermal spraying with a metallic silicon which contains a metal having an atomic number of 11 or less to reduce resistivity of the target material (for example, refer to PTL 5).

### CITATION LIST

### PATENT LITERATURE

[PTL 1] Japanese Unexamined Patent Application, First Publication No. H7-268616
[PTL 2] Japanese Patent No. 3819863
[PTL 3] Japanese Patent No. 4354721
[PTL 4] Japanese Unexamined Patent Application, First Publication No. 2002-173765
[PTL 5] Japanese Unexamined Patent Application, First Publication No. 2012-007218

### SUMMARY OF INVENTION

### TECHNICAL PROBLEM

With the method of producing a sputtering target proposed in PTLs 2 and 3, a high-density sputtering target having a sintered body density of 99% or higher can be obtained. However, during sputtering deposition using the obtained sputtering target, a deposition rate thereof is the same as that of a crystalline Si sputtering target, and there is still a problem in that breaking is likely to occur during sputtering.

In addition, PTL 4 proposes a sputtering target to which a silicide, which contains Si as a major component and further contains one selected from the high melting point metal group consisting of Mo, W, Ti, Nb, Cr, and Ta, is added. However, regarding this sputtering target, there are the following problems.
i) According to a general producing method including sintering to cooling steps, steps thereof are complicated, stress is likely to be generated due to addition of high melting point metal, residual stress is generated, and a sintered body is likely to crack. In addition, breaking is likely to occur during direct current (DC) sputtering deposition at a high power density.
ii) In order to secure the conductivity of a sputtering target, only 97 wt% of silicon can be added. When higher than 97 wt% of silicon is added, conductivity is eliminated. Therefore, a sputtering target having a silicon addition amount of 97 wt% or higher cannot be prepared.
iii) Since high melting point metal is used, the sputtering target cannot be applied to a method of producing a target through thermal spraying, and a sputtering target having a shape other than a flat plate shape, for example, a cylindrical sputtering target cannot be produced.

On the other hand, PTL 5 discloses a method of producing a conductive Si sputtering target through thermal spraying. However, the addition of a metal element having an atomic number of more than 11 is not disclosed. Therefore, during sputtering deposition using this Si sputtering target, a problem of a slow deposition rate cannot be solved.

Therefore, an object of the present invention is to provide a sputtering target containing Si as a major component, in which a bending strength of the sputtering target can be improved to suppress breaking, arcing during sputtering can be reduced, and high-speed film formation can be stably performed.

### SOLUTION TO PROBLEM

The present inventors obtained the following findings: by adding Ni or Al, and B or P to a Si sputtering target, resistance can be easily reduced, and the strength of the sputtering target can be improved.

It was found that, by adding Ni or Al, and B or P to a Si sputtering target, a sputtering target can be produced, of which the resistance can be reduced, which can be applied to direct current (DC) sputtering and medium frequency (MF) sputtering, in which sputtering deposition can be improved, and of which the bending strength can be improved and breaking resistance during machining and further during sputtering is superior.

Therefore, the present invention is obtained based on the above-described findings and adopts the following configurations in order to solve the above-described problems.
(1) According to the present invention, a sputtering target which is a sintered body is provided, containing: 0.5 at% to 10 at% of at least one metal element selected from Ni and Al; 0.01 ppm by weight to 10000 ppm by weight of B or P; and a balance including Si and inevitable impurities, in which the sintered body has a volume resistivity of 10 Ω_{·}cm or lower, a theoretical density ratio of 85% to 99%, and a bending strength of 65 N/mm² or higher.
(2) According to the present invention, a method of producing a sputtering target is provided, the method including: mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through pressing.
(3) According to the present invention, a method of producing a sputtering target is provided, the method including: mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through pressing.
(4) According to the present invention, a method of producing a sputtering target is provided, the method including: mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through thermal spraying.
(5) According to the present invention, a method of producing a sputtering target is provided, the method including: mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is 0.1 ppm by weight to 20000 ppm by weight; and sintering the mixed powder through thermal spraying.

As described above, the sputtering target according to the present invention is characterized in that it is a sintered body containing: 0.5 at% to 10 at% of at least one metal element selected from Ni and Al; 0.01 ppm by weight to 10000 ppm by weight of B or P; and a balance including Si and inevitable impurities, in which the sintered body has a volume resistivity of 10 Ω_{·}cm or lower, a theoretical density ratio of 85% to 99%, and a bending strength of 65 N/mm² or higher.

By adding Ni or Al, and B or P to Si, resistance can be easily reduced. Further, the strength of the sputtering target can be easily improved. In addition, even in a case where 99.5 at% of Si is contained, that is, even in a case where the amount of Si is low, the sputtering deposition rate can be improved, and a sputtering target which does not break during machining and further during sputtering can be produced. When the volume resistivity of a sputtering target is high, the sputtering target cannot be applied to direct current (DC) sputtering or medium frequency (MF) sputtering. When the bending strength of a sputtering target is insufficient, the sputtering target is likely to break. By adding Ni or Al, and B or P, the deposition rate can be increased to be higher than that of a sintering type Si sputtering target of the related art.

In addition, when the amount ofNi or Al added is 0.5 at% or lower, an effect of improving the bending strength and breaking resistance of a sputtering target cannot be obtained. On the other hand, when the amount of Ni or Al added is higher than 10 at%, a large amount of a silicide containing an added metal element is formed in a sputtering target. Therefore, the sputtering target is likely to be brittle, and arcing increases due to the silicide during sputtering. In a case where a sputtering target is produced using a powder sintering method or a thermal spray method, when the amount of Ni or Al added to the sputtering target is high, Ni or Al added is likely to be oxidized. Therefore, the oxygen content in the target increases, and arcing increases during sputtering. Although not limited thereto, the amount of at least one metal element selected from Ni and Al is preferably 0.5 at% to 8 at% and more preferably 3 at% to 8 at%. The metal element Ni or Al added to the sputtering target may be elemental Ni or Al, an alloy of Ni and Al, a compound of Ni and Si, or a compound of Al and Si. Further, the metal, the alloy, or the silicide may contain B or P.

Further, the sputtering target according to the present invention is characterized in that it contains 0.01 ppm by weight to 10000 ppm by weight of B or P. When the amount of B or P is 0.01 ppm by weight or lower, the in-plane electrical resistance distribution of the sputtering target deteriorates, and it is difficult to uniformly reduce the resistance. On the other hand, when the amount of B or P is higher than 10000 ppm by weight, a reaction between B or P and the added metal element (Ni or Al) accelerates, which causes an increase in arcing during sputtering or a decrease in the strength of the sputtering target. Although not limited thereto, the amount of B or P is preferably 0.01 ppm by weight to 5000 ppm by weight and more preferably 0.01 ppm by weight to 1000 ppm by weight.

Further, the sputtering target according to the present invention has a volume resistivity of 10 Ω_{·}cm or lower, a theoretical density ratio of 85% to 99%, and a bending strength of 65 N/mm² or higher. When the volume resistivity of a sputtering target is high, the sputtering target cannot be applied to direct current (DC) sputtering or medium frequency (MF) sputtering. Although not limited thereto, the volume resistivity is preferably 3 Ω_{·}cam or lower and more preferably 1 Ω_{·}cm or lower. In addition, since the sputtering target is formed using a sintering method, the theoretical density ratio is likely to vary depending on sintering conditions. When the theoretical density ratio is 85% or lower, arcing occurs frequently due to detachment of Si particles during sputtering. When the theoretical density ratio is 99% or higher, brittleness increases, and breaking is likely to occur during high-power sputtering. The theoretical density ratio is preferably 90% to 99% and more preferably 93% to 98%. Further, although not limited thereto, the bending strength is preferably 100 N/mm² or higher and more preferably 150 N/mm² or higher.

A method of producing a sputtering target according to the present invention is characterized in that 1) it includes: mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through pressing, or 2) it includes: mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through pressing.

In the method of producing a sputtering target having the above-described characteristics 1) and 2), B-doped or P-doped Si powder or mixed powder containing Si powder and B powder or P powder is used for powder sintering. Therefore, the electrical resistance distribution in the sputtering target can be made to be uniform. Further, by adopting this pressure sintering method, the bending strength of the target can be easily adjusted through selection of sintering conditions. Due to an increase in the bending strength of the target, target breaking can be suppressed, and stability during sputtering at a high power density can be improved.

In the producing method having the above-described characteristic 2), "Si powder having an average particle size of 150 µm or less" may contain B or P. That is, Si can be doped with B or P, or B or P can be added in the form of powder. In this case, the total amount of B or P may be 0.01 ppm by weight to 10000 ppm by weight.

In addition, a method of producing a sputtering target according to the present invention is characterized in that 3) it includes: mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and sintering the mixed powder through thermal spraying, or 4) it includes: mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is 0.1 ppm by weight to 20000 ppm by weight; and sintering the mixed powder through thermal spraying.

In the producing method having the above-described characteristics 3) and 4), high melting point metal is not used, and thus a sputtering target can be produced through thermal spraying. Through thermal spraying, a sputtering target having a shape other than a flat plate shape, for example, a cylindrical sputtering target can be produced. In a case where B and P as elemental powder are added to the raw material powder, a large amount of B and P evaporates at a high temperature during thermal spraying. Therefore, it is necessary that a larger amount of B and P than the amount in the desired composition of the target be added to the raw material powder to be sprayed. Thus, in the producing method having the above-described characteristics 3) and 4), it is preferable that the respective powders be mixed with each other such that the amount of B or P is 1 ppm by weight to 5000 ppm by weight. On the other hand, Ni or Al is more likely to be bonded than Si during thermal spraying, and the amount of Ni or Al in the target is likely to be higher than that in the raw material powder depending on thermal spraying conditions.

In the producing method having the above-described characteristic 4), "Si powder having an average particle size of 150 µm or less" may contain B or P. That is, Si can be doped with B or P, or B or P can be added in the form of powder.

### ADVANTAGEOUS EFFECTS OF INVENTION

As described above, the sputtering target according to the present invention is characterized in that it is a sintered body containing: 0.5 at% to 10 at% of at least one metal element selected from Ni and Al; 0.01 ppm by weight to 10000 ppm by weight of B or P; and a balance including Si and inevitable impurities, in which the sintered body has a volume resistivity of 10 Ω_{·}cm or lower, a theoretical density ratio of 85% to 99%, and a bending strength of 65 N/mm² or higher. Therefore, breaking or fracturing does not occur during machining for preparing a target. Further, during direct current (DC) sputtering or medium frequency (MF) sputtering at a high sputtering power density, arcing can be reduced, and breaking or fracturing can be prevented. Therefore, when the sputtering target according to the present invention is used, stability can be improved even during sputtering at a high sputtering power density, and high-speed film formation can be performed.

In addition, the method of producing a sputtering target according to the present invention includes: mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is a predetermined amount suitable for a sintering method, or mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is adjusted to be a predetermined amount suitable for a sintering method of pressing or thermal spraying; and sintering the mixed powder through pressing or thermal spraying. According to this producing method, a sintered body can be obtained which includes: 0.5 at% to 10 at% of at least one metal element selected from Ni and Al; 0.01 ppm by weight to 10000 ppm by weight of B or P; and a balance including Si and inevitable impurities, in which the sintered body has a volume resistivity of 10 Ω_{·}cm or lower, a theoretical density ratio of 85% to 99%, and a bending strength of 65 N/mm² or higher. In addition, a sputtering target can be produced with which high-speed film formation can be stably performed even during sputtering at a high sputtering power density.

### BRIEF DESCRIPTION OF DRAWINGS

FIG. 1 is an image showing the external appearance of a sputtering target of an example according to the present invention which was imaged after sputtering.
FIG. 2 is an image showing the external appearance of a sputtering target of a comparative example which was imaged after sputtering.

### DESCRIPTION OF EMBODIMENTS

Next, a sputtering target according to the present invention and a method of producing the same will be described below in detail using Examples.

### [Examples]

First, in order to produce the sputtering target, a Si material, a Ni material, an Al material, and B powder for doping were prepared.

Regarding the Si material, as shown in Table 1, a B-doped monocrystalline Si wafer, a B-doped polycrystalline Si block, a polycrystalline Si block having a purity of 6 N, a P-doped polycrystalline Si block, and a monocrystalline Si block were respectively crushed to obtain Si crushed powders. As a result, Si crushed powders of Examples 1 to 15 were prepared. The volume resistivity of the Si wafer or the Si block used in each of Examples before being crushed is shown in columns of "volume resistivity (Ω_{·}cm)" of Table 1. Each of them was crushed using a jaw crusher into coarse powder having a particle size of about 1 mm, and then was further crushed into powder having a constant average particle size using a disk crusher. In order to prevent oxidation during crushing, the crushing process using the disk crusher was performed in a N₂ atmosphere. The crushed powder was classified through a sieve. As the average particle size of the crushed powder, a D50 particle size measured using MICROTRAC was used. The average particle size of the Si crushed powder of each of Examples 1 to 15 is shown in columns of "Average Particle Size of Crushed Powder (µm)" of Table 1.

On the other hand, regarding the Ni material and the Al material, Ni powder, Ni silicide powder, and Al powder having an average particle size shown in Table 2 were used. As a B dopant, B powder having an average particle size shown in Table 2 was used. The average particle sizes of the Ni powder and the Al powder were measured using the same method as the above-described Si powder. Since oxygen management in the Ni powder and the Al powder is significantly important, oxygen content in material powder was measured, and material powder having a low oxygen content was selected.

Next, the Si crushed powder, either the Ni powder or the Al powder, and optionally the B powder were weighed such that the addition amounts were as shown in columns of "Addition Amount (wt%)" of Tables 1 and 2, and were mixed with each other as shown in columns of "Mixing Method" of Table 3. For mixing in each of Examples 1,2, and 13, a V-type mixer was used. For mixing in each of Examples 3, 4, 14, and 15, a dry ball mill was used. For mixing in each of Examples 5 to 12, a rocking mixer was used. The mixing time is shown in columns of "Mixing Time (hour)" of Table 3. Here, since the Al powder and the like have the risk of dust explosion, the above-described mixing was performed in an inert gas. In addition, during handling of mixed powder, it is necessary to avoid a spark generated by static electricity. Therefore, a countermeasure against a spark was taken. The amount of each composition element of the mixed powder other than B was measured through ICP-MASS. On the other hand, the B content was measured using ICP-MASS in a case of being 2 ppm by weight or lower and was measured through ICP atomic emission spectroscopy in a case of being 2 ppm by weight or higher. The results are shown in columns of "Composition Analysis of Mixed Powder" of Table 3.

The mixed powders of Examples 1, 3 to 6, and 8 to 10 were sintered through hot pressing (HP) or hot isostatic pressing (HIP) to obtain sintered bodies under conditions (heating rate, holding temperature, holding time, pressing pressure) shown in Table 4. Each of the sintered bodies was machined and was bonded to a backing plate. In this way, sputtering targets of Examples 1,3 to 6, and 8 to 10 were prepared. This hot pressing sintering was performed by putting each of the mixed powders into a graphite mold and pressurizing them in a vacuum or in an inert gas atmosphere. In the above-described producing method proposed in PTL 5, residual stress is removed by holding the temperature at 1200°C to 1300°C after sintering without pressurizing. In the examples according to the present invention, the pressureless holding was not performed after sintering.

In addition, in the mixed powders of Examples 2, 7, and 11 to 15, sintered bodies were prepared through thermal spraying. During this thermal spraying, each of the mixed powders was thermally sprayed onto a backing plate using a plasma spraying device (APS7100, manufactured by Aeroplasma Ltd.) under conditions of power: 120 kW and one pass: 50 µm. Thereby, each of the sintered body having a sprayed film with a thickness of 5 mm was prepared on the backing plate. Then, the sintered body was ground. In this way, sputtering targets of Examples 2, 7, and 11 to 15 were prepared. During the thermal spraying, cooling water was flowed on a back surface of the backing plate to suppress an increase in the temperature of the thermal-sprayed film and the substrate. In addition, the thermal spraying was performed in an inert gas atmosphere.

Regarding each of the sputtering targets of Examples 1 to 15, the prepared sintered body was crushed, and the composition thereof was analyzed through ICP-MASS or ICP atomic emission spectroscopy as described above. The results are shown in columns of "Target Composition Analysis" of Table 5.

### [Comparative Example]

For comparison to the examples according to the present invention, sputtering targets of Comparative Examples 1 to 14 were prepared. Amonocrystalline Si plate was used in the sputtering target of Comparative Example 1, a B-doped polycrystalline Si plate was used in the sputtering targets of Comparative Examples 2 and 3, and a polycrystalline Si plate was used in the sputtering target of Comparative Example 4. In addition, as a Si material, a B-doped polycrystalline Si block having a volume resistivity shown in Table 1 was used in Comparative Examples 5, 7 to 11, 13, and 14, and a polycrystalline Si block was used in Comparative Examples 6 and 12. These Si materials were crushed using the same method as in Examples to prepare Si crushed powders. In Comparative Example 5, the Si crushed powder and Ni powder were mixed with each other using a dry ball mill, and the mixed powder was sintered through hot pressing. In Comparative Examples 6 and 7, only the Si crushed powder was sintered through hot pressing. In Comparative Example 8, the Si crushed powder and Al powder were mixed with each other using a rocking mixer, and the mixed powder was sintered through hot pressing. In Comparative Example 9, the Si crushed powder, Ni powder, and Al powder were mixed with each other using a rocking mixer, and the mixed powder was sintered through hot pressing. In this way, sputtering targets of Comparative Examples 5, 6, 7, 8, and 9 were prepared for evaluation. In addition, in Comparative Example 10, W powder was used instead of a Ni material, the Si crushed powder and the W powder were mixed with each other using a dry ball mill, and the mixed powder was sintered through hot pressing. In Comparative Example 11, Mo powder was used instead of a Ni material, the Si crushed powder and the Mo powder were mixed with each other using a dry ball mill, and the mixed powder was sintered through thermal spraying. In this way, sputtering targets of Comparative Examples 10 and 11 were prepared. In order to prepare the sputtering target of Comparative Example 12, Si crushed powder was prepared using a high-resistance polycrystalline Si block, the Si crushed powder, Mo powder, and B powder were mixed with each other using a dry ball mill, and the mixed powder was sintered through thermal spraying.

The results of analyzing the compositions of the mixed powders of Comparative Examples 1 to 14 are shown in columns of "Composition Analysis of Mixed Powder" of Table 3. Regarding each of the sputtering targets of Comparative Examples 1 to 14, the bulk density thereof was measured, and the composition thereof was analyzed through ICP-MASS or ICP atomic emission spectroscopy after crushing. The results are shown in columns of "Target Composition Analysis" of Table 5.

**[Table 1]**

| | Si Material | | |
|---|---|---|---|
| | Form before Crushing | Volume Resistivity (Ω_{·}cm) | Average Particle Size of Crushed Powder (µm) |
| Example 1 | B-Doped Monocrystalline Si Wafer | 8 | 24 |
| Example 2 | B-Doped Polycrystalline Si Block | 9 | 76 |
| Example 3 | Polycrystalline Si Block | 2500 | 18 |
| Example 4 | Polycrystalline Si Block | 2500 | 18 |
| Example 5 | B-Doped Polycrystalline Si Block | 0.01 | 30 |
| Example 6 | B-Doped Polycrystalline Si Block | 0.01 | 127 |
| Example 7 | B-Doped Polycrystalline Si Block | 0.1 | 143 |
| Example 8 | B-Doped Polycrystalline Si Block | 0.1 | 38 |
| Example 9 | B-Doped Polycrystalline Si Block | 1 | 19 |
| Example 10 | P-Doped Polycrystalline Si Block | 0.1 | 28 |
| Example 11 | Polycrystalline Si Block | 1100 | 18 |
| Example 12 | Polycrystalline Si Block | 1100 | 18 |
| Example 13 | B-Doped Polycrystalline Si Block | 30 | 23 |
| Example 14 | B-Doped Polycrystalline Si Block | 21 | 41 |
| Example 15 | Monocrystalline Si Block | 7000 | 27 |
| Comparative Example 1 | Monocrystalline Si Plate | 9500 | - |
| Comparative Example 2 | B-Doped Polycrystalline Si Plate | 0.05 | - |
| Comparative Example 3 | B-Doped Polycrystalline Si Plate | 5 | - |
| Comparative Example 4 | Polycrystalline Si Plate | 2800 | - |
| Comparative Example 5 | B-Doped Polycrystalline Si Block | 0.1 | 165 |
| Comparative Example 6 | Polycrystalline Si Block | 1200 | 18 |
| Comparative Example 7 | B-Doped Polycrystalline Si Block | 0.1 | 28 |
| Comparative Example 8 | B-Doped Polycrystalline Si Block | 0.1 | 28 |
| Comparative Example 9 | B-Doped Polycrystalline Si Block | 0.1 | 28 |
| Comparative Example 10 | B-Doped Polycrystalline Si Block | 0.1 | 28 |
| Comparative Example 11 | B-Doped Polycrystalline Si Block | 0.2 | 28 |
| Comparative Example 12 | Polycrystalline Si Block | 1100 | 18 |
| Comparative Example 13 | B-Doped Polycrystalline Si Block | 0.1 | 28 |
| Comparative Example 14 | B-Doped Polycrystalline Si Block | 0.1 | 28 |

**[Table 2]**

| | Ni Material | | | Al Material | | | B Powder for Doping | | | Si Material |
|---|---|---|---|---|---|---|---|---|---|---|
| | Raw Material Form | Average Particle Size (µm) | Addition Amount (wt%) | Raw Material Form | Average Particle Size (µm) | Addition Amount (wt%) | Raw Material Form | Average Particle Size (µm) | Addition Amount (ppm by weight) | Addition Amount (wt%) |
| Example 1 | Ni Powder | 49 | 10 | - | - | - | - | - | - | Balance |
| Example 2 | - | - | - | Al Powder | 70 | 5 | - | - | - | Balance |
| Example 3 | Ni Powder | 44 | 5 | - | - | - | B Powder | 11 | 9900 | Balance |
| Example 4 | - | - | - | Al Powder | 92 | 2 | B Powder | 7 | 1000 | Balance |
| Example 5 | Ni Powder | 67 | 1 | - | - | - | - | - | - | Balance |
| Example 6 | - | - | - | Al Powder | 83 | 9.5 | - | - | - | Balance |
| Example 7 | Ni Powder | 36 | 13.6 | - | - | - | - | - | - | Balance |
| Example 8 | Ni Powder | 69 | 5.1 | Al Powder | 100 | 2.3 | - | - | - | Balance |
| Example 9 | NiSi Alloy Powder | 25 | 15 | - | - | - | - | - | - | Balance |
| Example 10 | NiSi₂ Alloy Powder | 31 | 20 | - | - | - | - | - | - | Balance |
| Example 11 | Ni Powder | 67 | 2 | - | - | - | B Powder | 7 | 0.2 | Balance |
| Example 12 | Ni Powder | 67 | 2 | - | - | - | B Powder | 7 | 19000 | Balance |
| Example 13 | - | - | - | Al Powder | 40 | 0.5 | - | - | - | Balance |
| Example 14 | - | - | - | Al Powder | 26 | 8.0 | - | - | - | Balance |
| Example 15 | - | - | - | Al Powder | 22 | 2.0 | B Powder | 10 | 5 | Balance |
| Comparative Example 1 | - | - | - | - | - | - | - | - | - | - |
| Comparative Example2 | - | - | - | - | - | - | - | - | - | - |
| Comparative Example 3 | - | - | - | - | - | - | - | - | - | - |
| Comparative Example 4 | - | - | - | - | - | - | - | - | - | - |
| Comparative Example 5 | Ni Powder | 49 | 10 | - | - | - | - | - | - | Balance |
| Comparative Example 6 | - | - | - | - | - | - | - | - | - | - |
| Comparative Example 7 | - | - | - | - | - | - | - | - | - | - |
| Comparative Example 8 | - | - | - | Al Powder | 70 | 0.3 | B Powder | 7 | 14000 | Balance |
| Comparative Example 9 | Ni Powder | 44 | 11.8 | Al Powder | 83 | 5.4 | - | - | - | Balance |
| Comparative Example 10 | W Powder | 15 | 36.3 | - | - | - | - | - | - | Balance |
| Comparative Example 11 | Mo Powder | 16 | 22.9 | - | - | - | - | - | - | Balance |
| Comparative Example 12 | Mo Powder | 16 | 22.9 | - | - | - | B Powder | 7 | 0.08 | Balance |
| Comparative Example 13 | - | - | - | Al Powder | 150 | 1.0 | B Powder | 7 | 14000 | Balance |
| Comparative Example 14 | Ni Powder | 49 | 10 | - | - | - | B Powder | 7 | 14000 | Balance |

**[Table 3]**

| | Mixing Method | Mixing Time (hour) | Composition Analysis of Mixed Powder (at%) | | | | | | |
|---|---|---|---|---|---|---|---|---|---|
| | | | Si | Ni (at%) | Al (at%) | B (ppm) | P (ppm) | Mo (at%) | W (at%) |
| Example 1 | V-Type Mixer | 1 | Balance | 5.0 | - | 0.01 | - | - | - |
| Example 2 | V-Type Mixer | 1 | Balance | - | 5.0 | 0.01 | - | - | - |
| Example 3 | Dry Ball Mill | 4 | Balance | 2.5 | - | 8750 | - | - | - |
| Example 4 | Dry Ball Mill | 4 | Balance | - | 2.0 | 940 | - | - | - |
| Example 5 | Rocking Mixer | 1 | Balance | 0.5 | - | 19 | - | - | - |
| Example 6 | Rocking Mixer | 1 | Balance | - | 9.7 | 20 | - | - | - |
| Example 7 | Rocking Mixer | 1 | Balance | 7.0 | - | 0.9 | - | - | - |
| Example 8 | Rocking Mixer | 1 | Balance | 2.5 | 2.5 | 0.9 | - | - | - |
| Example 9 | Rocking Mixer | 1 | Balance | 5.0 | - | 0.05 | - | - | - |
| Example 10 | Rocking Mixer | 1 | Balance | 5.0 | - | - | 1.1 | - | - |
| Example 11 | Rocking Mixer | 1 | Balance | 0.9 | - | 0.2 | - | - | - |
| Example 12 | Rocking Mixer | 1 | Balance | 1.0 | - | 19000 | - | - | - |
| Example 13 | V-Type Mixer | 3 | Balance | - | 0.5 | 0.02 | - | - | - |
| Example 14 | Dry Ball Mill | 5 | Balance | - | 7.9 | 0.02 | - | - | - |
| Example 15 | Dry Ball Mill | 10 | Balance | - | 2.1 | 3.2 | - | - | - |
| Comparative Example 1 | - | - | Balance | - | - | Measurement Lower Limit or Lower | - | - | - |
| Comparative Example 2 | - | - | Balance | - | - | 28 | - | - | - |
| Comparative Example 3 | - | - | Balance | - | - | 0.03 | - | - | - |
| Comparative Example 4 | - | - | Balance | - | - | Measurement Lower Limit or Lower | - | - | - |
| Comparative Example 5 | Dry Ball Mill | 4 | Balance | 5.0 | - | 1 | - | - | - |
| Comparative Example 6 | - | - | Balance | - | - | Measurement Lower Limit or Lower | - | - | - |
| Comparative Example 7 | - | - | Balance | - | - | 0.9 | - | - | - |
| Comparative Example 8 | Rocking Mixer | 1 | Balance | - | 0.3 | 13000 | - | - | - |
| Comparative Example 9 | Rocking Mixer | 1 | Balance | 6.0 | 6.0 | 1.2 | - | - | - |
| Comparative Example 10 | Dry Ball Mill | 4 | Balance | - | - | 1.1 | - | - | 8 |
| Comparative Example 11 | Dry Ball Mill | 4 | Balance | - | - | 0.9 | - | 8 | - |
| Comparative Example 12 | Dry Ball Mill | 4 | Balance | - | - | 0.08 | - | 8 | - |
| Comparative Example 13 | Rocking Mixer | 1 | Balance | - | 0.9 | 13500 | - | - | - |
| Comparative Example 14 | Dry Ball Mill | 4 | Balance | 5.1 | - | 13000 | - | - | - |

**[Table 4]**

| | Sintering Method | Heating Rate (°C/min) | Temperature (°C) | Time (hour) | Pressure (MPa) |
|---|---|---|---|---|---|
| Example 1 | HP | 3 | 1350 | 2 | 29 |
| Example 2 | Thermal Spraying | - | - | - | - |
| Example 3 | HP | 5 | 1400 | 2 | 34 |
| Example 4 | HP | 2 | 1400 | 2 | 34 |
| Example 5 | HP | 5 | 1300 | 3 | 40 |
| Example 6 | HIP | 8 | 650 | 1 | 150 |
| Example 7 | Thermal Spraying | - | - | - | - |
| Example 8 | HP | 3 | 1400 | 2 | 34 |
| Example 9 | HP | 3 | 1400 | 2 | 50 |
| Example 10 | HP | 3 | 1300 | 4 | 40 |
| Example 11 | Thermal Spraying | - | - | - | - |
| Example 12 | Thermal Spraying | - | - | - | - |
| Example 13 | Thermal Spraying | - | - | - | - |
| Example 14 | Thermal Spraying | - | - | - | - |
| Example 15 | Thermal Spraying | - | - | - | - |
| Comparative Example 1 | - | - | - | - | - |
| Comparative Example 2 | - | - | - | - | - |
| Comparative Example 3 | - | - | - | - | - |
| Comparative Example 4 | - | - | - | - | - |
| Comparative Example 5 | HP | 5 | 1200 | 4 | 34 |
| Comparative Example 6 | HP | 2 | 1400 | 2 | 34 |
| Comparative Example 7 | HP | 5 | 1350 | 3 | 34 |
| Comparative Example 8 | HP | 8 | 1300 | 3 | 34 |
| Comparative Example 9 | HP | 5 | 1420 | 2 | 50 |
| Comparative Example 10 | HP | 5 | 1350 | 2 | 34 |
| Comparative Example 11 | Thermal Spraying | - | - | - | - |
| Comparative Example 12 | Thermal Spraying | - | - | - | - |
| Comparative Example 13 | HP | 3 | 1300 | 3 | 34 |
| Comparative Example 14 | HP | 5 | 1200 | 4 | 34 |

**[Table 5]**

| | Composition Analysis of Target (at%) | | | | | | |
|---|---|---|---|---|---|---|---|
| | Si | Ni (at%) | Al (at%) | B (ppm) | P (ppm) | Mo (at%) | W (at%) |
| Example 1 | Balance | 4.8 | - | 0.01 | - | - | - |
| Example 2 | Balance | - | 5 | 0.01 | - | - | - |
| Example 3 | Balance | 2.3 | - | 7930 | - | - | - |
| Example 4 | Balance | - | 2.1 | 890 | - | - | - |
| Example 5 | Balance | 0.6 | - | 15 | - | - | - |
| Example 6 | Balance | - | 9.5 | 18 | - | - | - |
| Example 7 | Balance | 7.1 | - | 0.7 | - | - | - |
| Example 8 | Balance | 2.6 | 2.6 | 0.6 | - | - | - |
| Example 9 | Balance | 4.9 | - | 0.03 | - | - | - |
| Example 10 | Balance | 4.9 | - | - | 1 | - | - |
| Example 11 | Balance | 0.9 | - | 0.04 | - | - | - |
| Example 12 | Balance | 0.9 | - | 9300 | - | - | - |
| Example 13 | Balance | - | 0.6 | 0.02 | - | - | - |
| Example 14 | Balance | - | 8.7 | 0.01 | - | - | - |
| Example 15 | Balance | - | 2.4 | 0.05 | - | - | - |
| Comparative Example 1 | Balance | - | - | Measurement Lower Limit or Lower | - | - | - |
| Comparative Example 2 | Balance | - | - | 29 | - | - | - |
| Comparative Example 3 | Balance | - | - | 0.02 | - | - | - |
| Comparative Example 4 | Balance | - | - | Measurement Lower Limit or Lower | - | - | - |
| Comparative Example 5 | Balance | 5.1 | - | 0.8 | - | - | - |
| Comparative Example 6 | Balance | - | - | Measurement Lower Limit or Lower | - | - | - |
| Comparative Example 7 | Balance | - | - | 0.9 | - | - | - |
| Comparative Example 8 | Balance | - | 0.3 | 13500 | - | - | - |
| Comparative Example 9 | Balance | 5.8 | 5.8 | 1 | - | - | - |
| Comparative Example 10 | Balance | - | - | 1 | - | - | 8 |
| Comparative Example 11 | Balance | - | - | 0.8 | - | 8.2 | - |
| Comparative Example 12 | Balance | - | - | Measurement Lower Limit or Lower | - | 8.2 | - |
| Comparative Example 13 | Balance | - | 0.7 | 14000 | - | - | - |
| Comparative Example 14 | Balance | 5 | - | 13600 | - | - | - |

Regarding each of the sputtering targets of Examples 1 to 15 and Comparative Examples 1 to 14 prepared as described above, a theoretical density ratio, a bending strength, and a volume resistivity (specific resistance) were measured, and the external appearance thereof after machining and bonding was inspected.

### <Measurement of Theoretical Density Ratio>

The theoretical density ratio of each of the sputtering targets of Examples 1 to 15 and Comparative Examples 5 to 14 was calculated by measuring the bulk density of each of the sintered bodies of Examples 1 to 15 and Comparative Examples 5 to 14 and obtaining a ratio of the theoretical density of the sintered body to the measured bulk density. The results are shown in columns of "Target Theoretical Density Ratio (%)" of Table 6. In the sputtering targets of Comparative Examples 1 to 4, a monocrystalline or polycrystalline Si block was used, and thus the theoretical density ratio was 100%.

Here, the theoretical density of the sintered body was calculated from the following expression.

Theoretical Density of Sintered Body=100/(a/A+b/B+c/C)
A: density of Si single crystal
a%: weight proportion of Si in sintered body
B: density of pure Ni (or W) metal
b%: weight proportion of Ni (or W) in sintered body
C: density of pure Al (or Mo) metal
c%: weight proportion of Al (or Mo) in sintered body

Regarding B and P, the addition amount thereof is small and thus is not considered to calculate the theoretical density.

### <Measurement of Bending Strength>

For the measurement of the bending strength, the sintered bodies of Examples 1 to 15 and Comparative Examples 5 to 14 obtained as described above were machined, and ten samples having a size of 40 mmx3 mmx4 mm were prepared for each of the sintered bodies. Three-point bending strengths of the samples were measured according to JIS R 1601:2008 (based on ISO 14704:2000). The average value of the ten samples was set as a measured value of the bending strength. The measurement results are shown in columns of "Bending Strength (N/mm²)" of Table 6.

### <Measurement of Volume Resistivity>

The volume resistivity (specific resistance) of each of the sputtering targets of Examples and Comparative Examples prepared as described above was measured using a resistance-measuring device. In a case where the volume resistivity value was 1000 Ω_{·}cm or lower, a resistance-measuring device LORESTA (manufactured by Mitsubishi Gas Chemical Company Inc.) was used. In a case where the volume resistivity value was 1000 Ω_{·}cm or higher, a resistance-measuring device HIRESTA (manufactured by Mitsubishi Gas Chemical Company Inc.) was used.

The measurement results are shown in columns of "Specific Resistance (Ω_{·}cm)" of Table 6.

### <External Appearance after Machining and Bonding>

In the process of preparing the sputtering targets of Examples 1 to 15 and Comparative Examples 1 to 14 as described above, the external appearance regarding breaking or fracturing was investigated by visual inspection after machining and after bonding to the backing plate. The inspection results are shown in columns of "External Appearance after Machining and Bonding" of Table 6.

Next, each of the sputtering targets of Examples 1 to 15 and Comparative Examples 1 to 14 prepared as described above was machined into a sample having a size of φ125 mmxthickness 5 mm, and using this sample, a film formation test was performed. In this film formation test, sputtering deposition was performed using a direct current (DC) power supply (RPG-50, manufactured by MKS Instruments) in an atmosphere of pure Ar (represented by "Only Ar"), mixed gas of Ar and oxygen (represented by "Ar+Oxygen"), or pure oxygen gas (represented by "Pure Oxygen"). The deposition rate and the number of times of arcing during sputtering were measured. Further, the external appearance of the target after sputtering was investigated.

### < Measurement of Deposition Rate>

Using the sputtering targets of Examples 1 to 15 and Comparative Examples 1 to 14 prepared as described above, sputtering was performed on a glass substrate under the following conditions. As the atmosphere gas of sputtering, only Ar, Ar+oxygen, or pure oxygen was used to form a Si film. In the case of each atmosphere gas, the deposition rate was measured. In the case of Ar+oxygen, a volume ratio Ar/oxygen of Ar to oxygen was 1/1.
·Input power: DC 1000 W
·Distance between target and substrate: 70 mm
·Horizontal magnetic field: 2000 gauss
·Substrate Heating: not performed
·Deposition time: 60 sec
·Film thickness measurement method: measurement using a probe type surface profiler
·Calculation of deposition rate: deposition rate = (film thickness)/(deposition time)

The measurement results of the above-described film formation are shown in columns of "Deposition Rate (nm/sec)" of Table 7. Regarding the sputtering targets of Comparative Examples 1, 4, 6, 11, and 12, DC sputtering was not able to be performed. Therefore, the deposition rate was not measured, and the results are shown as "DC Sputtering Not Able to Be Performed" in the table. In Comparative Example 10, arcing occurred frequently, and the film formation test was not able be performed. Therefore, the deposition rate was not performed.

### <Measurement of Number of Times of Acing>

Sputtering was performed in Ar+oxygen gas (Ar/oxygen=1/1; volume ratio) under conditions of input power: 1250 W and 1 hour to measure the frequency of arcing (number of times/hour). The results are shown in columns of "Number of Times of Arcing (/hour)" of Table 7.

### <External Appearance of Target after Sputtering>

After sputtering was performed to measure the deposition rate and the number of times of arcing of each of the sputtering targets of Examples 1 to 15 and Comparative Examples 1 to 14 prepared as described above, a sputter chamber was opened to investigate the external appearance of the sputtering target in the chamber regarding breaking or fracturing by visual inspection. The inspection results are shown in columns of "External Appearance after Sputtering" of Table 7. Using the sputtering targets of Comparative Examples 1, 4, 6, 11, and 12, DC sputtering was not able to be performed. Therefore, the results are shown as "DC Sputtering Not Able to Be Performed" in Table 6, and the deposition rate and the number of times of arcing were not measured. In addition, in Comparative Example 5, target breaking occurred during sputtering deposition, and the sputtering deposition was stopped. In Comparative Example 10, arcing occurred frequently, and cracking occurred. Therefore, the film formation test was not able to be continued.

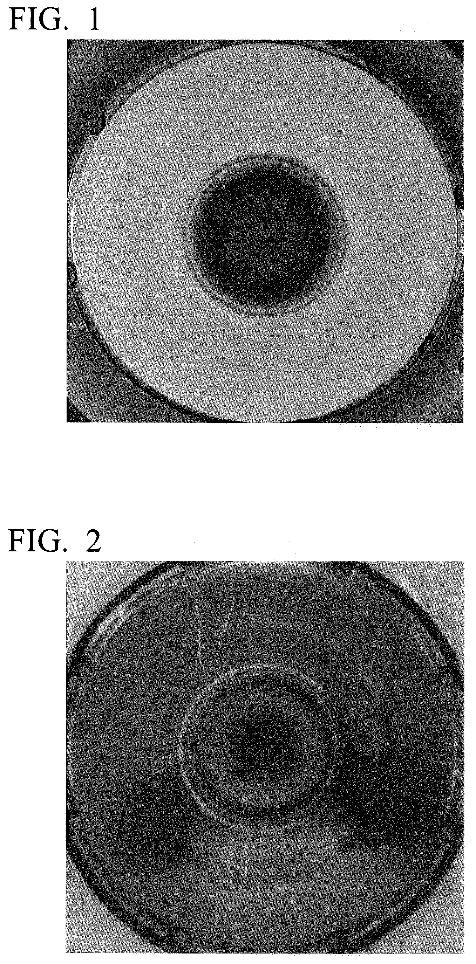

Here, FIG. 1 is an image showing the external appearance of the sputtering target of Example 5 which was imaged after sputtering. FIG. 2 is an image showing the external appearance of the sputtering target of Comparative Example 2 which was imaged after sputtering. In Example 5 shown in FIG. 1, breaking or fracturing was not observed and there were no abnormalities even after sputtering. On the other hand, in Comparative Example 2 shown in FIG. 2, cracking was observed after sputtering.

Regarding the external appearance of the target, in a case where the target was broken into two or more parts, it was determined that breaking occurred. In a case where a fracture having a length of less than 5 mm was observed without the target being broken, it was determined that fracturing occurred. In a case where a fracture having a length of 5 mm or more was observed without the target being broken, it was determined that cracking occurred.

**[Table 6]**

| | Theoretical Density Ratio of Target (%) | Bending Strength (N/mm²) | Specific Resistance (Ω·cm) | External Appearance after Machining and Bonding |
|---|---|---|---|---|
| Example 1 | 88 | 123 | 6 | No Breaking and Fracturing |
| Example 2 | 95 | 84 | 8 | No Breaking and Fracturing |
| Example 3 | 91 | 164 | 0.01 | No Breaking and Fracturing |
| Example 4 | 93 | 78 | 0.03 | No Breaking and Fracturing |
| Example 5 | 91 | 65 | 0.04 | No Breaking and Fracturing |
| Example 6 | 91 | 108 | 0.1 | No Breaking and Fracturing |
| Example 7 | 94 | 110 | 0.2 | No Breaking and Fracturing |
| Example 8 | 92 | 85 | 0.4 | No Breaking and Fracturing |
| Example 9 | 99 | 95 | 3 | No Breaking and Fracturing |
| Example 10 | 97 | 91 | 1 | No Breaking and Fracturing |
| Example 11 | 94 | 104 | 3 | No Breaking and Fracturing |
| Example 12 | 88 | 86 | 0.06 | No Breaking and Fracturing |
| Example 13 | 91 | 70 | 9 | No Breaking and Fracturing |
| Example 14 | 94 | 96 | 7 | No Breaking and Fracturing |
| Example 15 | 93 | 81 | 8 | No Breaking and Fracturing |
| Comparative Example 1 | 100 | - | 10000 | No Breaking and Fracturing |
| Comparative Example 2 | 100 | - | 0.05 | No Breaking and Fracturing |
| Comparative Example 3 | 100 | - | 5 | No Breaking and Fracturing |
| Comparative Example 4 | 100 | - | 2900 | No Breaking and Fracturing |
| Comparative Example 5 | 80 | 55 | 1.3 | Small Amount of Fracturing |
| Comparative Example 6 | 91 | 86 | 1300 | No Breaking and Fracturing |
| Comparative Example 7 | 90 | 73 | 0.5 | No Breaking and Fracturing |
| Comparative Example 8 | 78 | 56 | 0.02 | No Breaking and Fracturing |
| Comparative Example 9 | 100 | 149 | 0.4 | No Breaking and Fracturing |
| Comparative Example 10 | 95 | 61 | 0.3 | Small Amount of Fracturing |
| Comparative Example 11 | 81 | 47 | 3 | Breaking, Sputtering Impossible |
| Comparative Example 12 | 80 | 47 | 860 | Fracturing |
| Comparative Example 13 | 82 | 50 | 0.03 | No Breaking and Fracturing |
| Comparative Example 14 | 80 | 56 | 0.01 | No Breaking and Fracturing |

**[Table 7]**

| | Deposition Rate (nm/sec) | | | Number of Times of Arcing (/hour) | External Appearance of Target after Sputtering |
|---|---|---|---|---|---|
| | Only Ar | Ar+Oxygen | Pure Oxygen | | |
| Example 1 | 3.5 | 1.6 | 1.0 | 591 | No Breaking, Fracturing, and Abnormalities |
| Example 2 | 3.2 | 2.0 | 1.2 | 255 | No Breaking, Fracturing, and Abnormalities |
| Example 3 | 2.9 | 1.7 | 0.9 | 604 | No Breaking, Fracturing, and Abnormalities |
| Example 4 | 2.7 | 1.3 | 0.9 | 421 | No Breaking, Fracturing, and Abnormalities |
| Example 5 | 3.7 | 2.1 | 1.1 | 249 | No Breaking, Fracturing, and Abnormalities |
| Example 6 | 3.6 | 1.3 | 1.0 | 197 | No Breaking, Fracturing, and Abnormalities |
| Example 7 | 2.9 | 1.5 | 1.0 | 321 | No Breaking, Fracturing, and Abnormalities |
| Example 8 | 2.8 | 1.4 | 1.0 | 532 | No Breaking, Fracturing, and Abnormalities |
| Example 9 | 2.9 | 1.4 | 1.0 | 391 | No Breaking, Fracturing, and Abnormalities |
| Example 10 | 3.2 | 1.8 | 1.0 | 229 | No Breaking, Fracturing, and Abnormalities |
| Example 11 | 3.2 | 2.0 | 1.0 | 242 | No Breaking, Fracturing, and Abnormalities |
| Example 12 | 3.1 | 2.0 | 1.0 | 203 | No Breaking, Fracturing, and Abnormalities |
| Example 13 | 3.1 | 2.0 | 1.2 | 307 | No Breaking, Fracturing, and Abnormalities |
| Example 14 | 3.7 | 1.8 | 0.9 | 136 | No Breaking, Fracturing, and Abnormalities |
| Example 15 | 3.3 | 1.9 | 1.2 | 240 | No Breaking, Fracturing, and Abnormalities |
| Comparative Example 1 | DC Sputtering Not Able to Be Performed | | | | |
| Comparative Example 2 | 0.9 | 0.9 | 0.8 | 28440 | Cracking |
| Comparative Example 3 | 0.8 | 0.7 | 0.6 | 35627 | Cracking |
| Comparative Example 4 | DC Sputtering Not Able to Be Performed | | | | |
| Comparative Example 5 | 3.4 | 1.4 | 0.9 | Sputtering Stopped Due to Breaking | |
| Comparative Example 6 | DC Sputtering Not Able to Be Performed | | | | |
| Comparative Example 7 | 1.2 | 1.0 | 0.8 | 1984 | Cracking |
| Comparative Example 8 | 1.9 | 1.6 | 0.9 | 8432 | Cracking |
| Comparative Example 9 | 3.5 | 1.7 | 1.0 | 8567 | Cracking |
| Comparative Example 10 | Film Formation Test Not Able to Be Performed Due to Frequent Arcing | | | 43895 | Cracking |
| Comparative Example 11 | DC Sputtering Not Able to Be Performed | | | | |
| Comparative Example 12 | DC Sputtering Not Able to Be Performed | | | | |
| Comparative Example 13 | 2.0 | 1.6 | 1.0 | 7321 | Cracking |
| Comparative Example 14 | 1.9 | 1.4 | 1.0 | 6302 | Cracking |

According to the results shown in Tables 6 and 7 above, it can be seen that, in all the Si sputtering targets of Examples 1 to 15, by adding Ni or Al, and B or P, the theoretical density ratio was improved to 85% to 99%, and the bending strength was improved to be 65 N/mm² or higher. Further, the volume resistivity (specific resistance) was also 10 Ω_{·}cm or lower, which implies that the resistance was reduced such that DC sputtering or MF sputtering can be performed. In all the Examples 1 to 15, target breaking or fracturing did not occur in the process of producing the target. Furthermore, during sputtering deposition using the Si sputtering targets of Examples 1 to 15, the deposition rate was improved by adding Ni or Al. In addition, the number of times of arcing was able to be reduced, and abnormalities such as breaking or fracturing were not observed on the external appearance of the target after sputtering. In Examples 9 and 10, Ni silicide powder was added, and the same effect as in a case where Ni powder was added was obtained.

On the other hand, in Comparative Examples 1, 4, 6, and 12 in which Ni or Al, and B or P was not substantially added, the specific resistance was high. Therefore, DC sputtering was not performed. In Comparative Examples 2 and 3 in which Ni or Al was not added, arcing occurred frequently, and target breaking or fracturing did not occur during the producing of the sputtering target. However, cracking occurred after sputtering. In Comparative Example 5, the bending strength was low, breaking occurred during sputtering, and thus sputtering deposition was stopped. In Comparative Examples 7 and 9, the number of times of arcing was large, and cracking occurred. In Comparative Example 8, the bending strength was low, and cracking occurred. In Comparative Example 10 in which the W powder was added, a small amount of fracturing was observed after machining and bonding, and the number of times of arcing was large. Therefore, the film formation test was stopped. In addition, in Comparative Examples 11 and 12 in which the Mo powder was added and the target was produced through thermal spraying, the bending strength was low, and breaking and fracturing were observed after machining and bonding. Therefore, sputtering was not performed. In Comparative Examples 13 and 14, the theoretical density ratio and the bending strength of the target were low, arcing occurred frequently during sputtering, and cracking occurred.

As described above, the sputtering target of each of the examples according to the present invention contains Si as a major component and further contains 0.5 at% to 10 at% of at least one metal element selected from Ni and Al, and 0.01 ppm by weight to 10000 ppm by weight of B or P, in which the sputtering target has a volume resistivity of 10 Ω_{·}cm or lower, a theoretical density ratio of 85% to 99%, and a bending strength of 65 N/mm² or higher. Therefore, it can be seen that breaking resistance can be improved due to an increase in the bending strength of the sputtering target, arcing can be reduced during sputtering, and high-speed film formation can be stably performed even during high-power sputtering.

### INDUSTRIAL APPLICABILITY

According to the present invention, breaking or fracturing does not occur during machining or sputtering, and arcing can be reduced during direct current sputtering or medium frequency sputtering at a high sputtering power density. Therefore, the present invention is suitably applicable to the formation of a silicon film, a silicon nitride film, and a silicon oxide film.

## Claims

1. A sputtering target which is a sintered body, comprising:
0.5 at% to 10 at% of at least one metal element selected from Ni and Al;
0.01 ppm by weight to 10000 ppm by weight of B or P; and
a balance including Si and inevitable impurities,
wherein the sintered body has a volume resistivity of 10 Ω_{·}cm or lower, a theoretical density ratio of 85% to 99%, and a bending strength of 65 N/mm² or higher.

2. A method of producing a sputtering target, the method comprising:
mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and
sintering the mixed powder through pressing.

3. A method of producing a sputtering target, the method comprising:
mixing Si powder having an average particle size of 150 µm or less and B powder or P powder, with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and
sintering the mixed powder through pressing.

4. A method of producing a sputtering target, the method comprising:
mixing Si powder containing B or P and having an average particle size of 150 µm or less with powder containing at least one metal element selected from Ni and Al or silicide powder containing the at least one metal element to obtain a mixed powder such that a total amount of Ni and Al is 0.5 at% to 10 at% and an amount of B or P is 0.01 ppm by weight to 10000 ppm by weight; and
sintering the mixed powder through thermal spraying.

5. A method of producing a sputtering target, the method comprising:
mixing Si powder having an average particle size of 150 µm or less, and B powder or P powder with powder containing at least one metal element selected from Ni and Al or silicide powder containing the at least one metal element to obtain a mixed powder such that a total amount of Ni and Al is 0.5 at% to 10 at% and an amount of B or P is 0.1 ppm by weight to 20000 ppm by weight; and
sintering the mixed powder through thermal spraying.
